# EUROPEAN PATENT APPLICATION

(11) **EP 4 582 597 A1**
(43) Date of publication of application: **09.07.2025**
(21) Application number: 23860708.9
(22) Date of filing: 31.07.2023
(51) Int. Cl.: C25D 5/00, C25D 3/38, H05K 1/09, H05K 3/38, H05K 3/18

(54) **SURFACE-TREATED COPPER FOIL HAVING PILLAR NODULE STRUCTURE, AND COPPER CLAD LAMINATE AND PRINTED WIRING BOARD COMPRISING SAME**

(30) Priority: 30.08.2022 KR 20220109056
(71) Applicant: LOTTE ENERGY MATERIALS CORPORATION, Iksan-si, Jeollabuk-do 54586 (KR)
(72) Inventor: SEO, Jung Woo, Iksan-si Jeollabuk-do 54586 (KR); YANG, Chang Yol, Iksan-si Jeollabuk-do 54586 (KR); CHOI, Eun Sil, Iksan-si Jeollabuk-do 54586 (KR)
(74) Representative: Mammel und Maser Patentanwälte PartG mbB
(86) International application number: PCT/KR2023/011116
(87) International publication number: WO 2024/049027

(57) **Abstract**

A surface-treated copper foil, which has an excellent adhesive strength with respect to a resin substrate and is suitable for application to a high frequency foil, is disclosed. The present invention provides the surface-treated copper foil comprising a surface-treated side formed by surface treatment of an original foil, the surface-treated copper foil comprising a plurality of nodule structures formed on the surface-treated side, wherein the nodule structures include: a pillar part extending from the surface of the surface-treated copper foil; and a branch part extending from a side or an end portion of the pillar part, wherein the surface roughness (Rz) of the surface-treated side is 1.0 µm or less.

## Description

### [Technical Field]

The present disclosure relates to a surface-treated copper foil and, more specifically, to a surface-treated copper foil having excellent adhesive strength to a resin substrate and being suitable for application as a high-frequency foil, a copper clad laminate including the same, and a printed wiring board including the same.

### [Background Art]

With the acceleration of downsizing and weight reduction of electric/electronic devices, printed circuits formed on substrates have become more sophisticated, highly integrated, and downsized, so that copper foils used in printed circuit boards are required to have various properties.

Composite materials for boards used in the manufacture of flexible boards, multilayer boards for high-density mounting, high-frequency circuit boards, and the like (hereinafter, these boards being collectively referred to as "circuit boards" or "printed wiring boards") used in the electric/electronic devices are composed of conductors (copper foils) and an insulating substrate (including a film) supporting the conductor, and the insulating substrate ensures insulation between conductors and has enough strength to support components.

Conventionally, in order to enhance the adhesive strength to the insulating substrate, the 10-point mean roughness Rz was increased by amplifying the current flowing at the time of surface treatment and increasing the amount of granular copper deposited at the time of surface treatment. However, such a method is suitable as a method for enhancing the adhesive strength, but is not suitable in circuit boards considering high-frequency characteristics since excessive treatment of copper foil surfaces for enhancement of adhesive strength increases interference factors in high-frequency signal transmission, which adversely affects signal transmission.

In recent years, data transmission speeds have increased by 100 times or more in the 5G high-frequency environment. As for printed wiring boards used for high-frequency and high-speed transmission in the 5G environment, the market for printed circuit boards employing low-loss, ultra-fine, high-density liquid crystal polymers (LCPs) is rapidly growing. LCPs have a similar coefficient of thermal expansion (CTE) to copper, have excellent impact strength that doesn't break by external shocks or vibrations, and are excellent compared with polyimides (PIs) in terms of moisture absorption resistance, a property of resisting moisture absorption, in high-frequency environments. However, conventional LCPs have problems, such as poor adhesion and heat resistance and unfavorable adhesion to copper foils and processability, similar to low-dielectric-loss resins or other thermosetting resins.

### [Disclosure]

### [Technical Problem]

The present disclosure has been made to solve the above-mentioned problems, and an aspect of the present disclosure is to provide a novel surface-structured, surface-treated copper foil having high adhesive strength to printed wiring boards, a copper clad laminate including the same, and a printed wiring board including the same.

Another aspect of the present disclosure is to provide a surface-treated copper foil having a surface roughness suitable for high-frequency signal transmission, a copper clad laminate including the same, and a printed wiring board including the same.

Still another aspect of the present disclosure is to provide a surface-treated copper foil having high adhesive strength to a printed wiring board employing a liquid crystal polymer (LCP), a copper clad laminate including the same, and a printed wiring board including the same.

### [Technical Solution]

In accordance with an aspect of the present disclosure, there is provided a surface-treated copper foil including a surface-treated surface formed by surface treatment of a raw foil, wherein the surface-treated copper foil includes a plurality of nodule structures formed on the surface-treated surface, the nodule structures each including: a pillar part extending from the surface of the surface-treated copper foil; and a branch part extending from a side surface or an end portion of the pillar part, and wherein the surface-treated surface has a surface roughness (Rz) of 1.0 um or less.

The surface roughness (Rz) of the surface-treated surface is preferably 0.7 um or less.

The width (w) of the nodule structures is preferably 400 nm or less and the ratio (h/w) of the height (h) to the width (w) of the nodule structures preferably exceeds 1. In addition, the ratio (h/w) of the height (h) to the width (w) of the nodule structures may be 1.2 or more.

The width (w) of the nodule structures may be 130-350 nm; the height (h) of the nodule structures may be 300-550 nm; and the distance (d) between the nodule structures may be 200 nm or more. Preferably, the distance (d) between the nodule structures may be 250-600 nm.

The density of the nodule structures may be 2-20/µm².

The glossiness of the surface-treated surface of the surface-treated copper foil may be less than 10.

In accordance with another aspect of the present disclosure, there is provided a copper clad laminate including the above-described surface-treated copper foil laminated on a resin substrate. The resin substrate may include an LCP resin.

### [Advantageous Effects]

According to the present disclosure, novel surface-structured, surface-treated copper foils having high adhesive strength to printed circuit boards can be provided. Furthermore, according to the present disclosure, surface-treated copper foils having surface roughness suitable for high-frequency signal transmission and high adhesive strength applicable to printed circuit boards employing a liquid crystal polymer (LCP) can be provided.

### [Description of Drawings]

FIG. 1 is a schematic diagram of nodule structures on the surface of a copper foil according to an embodiment of the present disclosure.
FIGS. 2 to 4 are scanning electron microscopic images of surfaces of surface-treated copper foils prepared in Example 1, Comparative Example 1, and Comparative Example 2 of the present disclosure, respectively.
FIGS. 5A and 5B are images of surfaces of LCP resins after the surface-treated copper foils prepared in an example and a comparative example of the present disclosure were attached to the LCP resins and then copper foils were removed by complete etching.
FIG. 6 is a graph showing XPS analysis results of a sample before and after the measurement of adhesive strength of a surface-treated copper foil prepared in an example of the present disclosure.

### [Best Mode]

The features described in exemplary embodiments and drawings shown herein are for merely illustrating one of the most preferable exemplary embodiments but are not intended to represent the technical idea of the present disclosure, and thus the present disclosure may cover various equivalents and modifications which can substitute for the exemplary embodiments at the time of filing the present application. Hereinafter, exemplary embodiments of the present disclosure will be described in more detail with reference to the accompanying drawings.

Herein, values of factors expressing dimensions, such as width, height, and length of a structure, or measurement values of the characteristics of a structure, indicate mean values, unless otherwise specified.

A surface-treated copper foil of the present disclosure includes a raw foil and a surface-treated layer on at least one surface of the raw foil. In the present disclosure, the surface-treated layer may include a roughened layer and an anti-oxidation layer and may further include a chromate layer or an additional layer.

Hereinafter, the raw foil, roughened layer, and anti-oxidation layer of the present disclosure will be described in detail.

### A. Raw foil

In the present disclosure, a known copper foil may be used as a raw copper foil without limitation. According to an embodiment, an untreated copper foil may be an electroplated copper foil or a rolled copper foil.

In the present disclosure, the thickness of the raw foil is not particularly limited, but when a surface-treated copper foil is used for a printed wiring board, the thickness of the raw foil may be, for example, 6 to 35 µm, and preferably 6 to 18 µm.

In the present disclosure, as for the electroplated foil, the surface roughness Rz of a deposition side of the raw foil may be 0.7 µm, more preferably, 0.65 µm or less, 0.6 µm or less, 0.5 µm or less, or 0.45 µm or less. In the present disclosure, the raw foil has a tensile strength of, preferably, 40 kgf/mm² to 70 kgf/mm².

In the present disclosure, the mechanical properties of the raw foil are preferably maintained to be uniform before and after hot pressing during the binding with a prepreg for molding a copper clad laminate or a printed wiring board. In the present disclosure, the raw foil has a very small change in crystal grains before and after pressing.

### B. Roughened layer

In the present disclosure, the roughened layer may be formed on one surface or both surfaces of the raw foil. The surface-treated layer of the present disclosure may be formed by electroplating the raw foil.

An aqueous solution of pH 1-8 (e.g., 6 to 7) containing 10 to 90 g/L of a copper salt, 30 to 150 g/L of sulfuric acid, 0.1 to 0.5 g/L of cobalt, 0.2 to 2 g/L of tungsten, and 0.2 to 2 g/L of titanium may be used as an electrolyte. Examples of the copper salt may include copper sulfate (CuSO₄), copper nitrate (Cu(NO₃)₂), copper chloride (CuCl₂), and copper acetate (Cu(CH₃COO)₂).

Electro-plating may be, for example, conducted at a solution temperature of 25 to 45°C and a current density of 16 to 20 A/dm² for, for example, 5 to 15 seconds while the raw foil is immersed in an electrolyte by using an insoluble electrode as a cathode and an untreated raw foil as an anode, but is not limited thereto.

### C. Anti-oxidation layer

Additionally, in the present disclosure, an anti-oxidation layer may be formed on the surface-treated layer. The anti-oxidation layer may contain nickel (Ni) and phosphorus (P). The anti-oxidation layer may further contain, zinc (Zn), cobalt (Co), titanium (Ti), tin (Sn), and the like, if necessary, in addition to nickel and phosphorus.

The deposition amount of the anti-oxidation layer may be, for example, 30 to 300 mg/m², or as another example, 50 to 120 mg/m², but is not limited thereto.

In the present disclosure, a method of forming the anti-oxidation is not particularly limited. Illustratively, the anti-oxidation may be formed by plating in an aqueous solution containing 3 to 10 g/L of a nickel salt and 15 to 40 g/L of phosphoric acid (H₃PO₄) at a solution temperature of 25°C, pH 2-4, and a current density of 1 A/dm² for 1 to 3 seconds and then plating in an aqueous solution containing 3 to 10 g/L of zinc and having pH 1-3 at a current density of 1 A/dm² for 2 to 4 seconds.

Particularly, examples of the nickel salt may include nickel sulfate (NiSO₄), nickel nitrate (Ni(NO₃)₂), nickel chloride (NiCl₂), nickel acetate (C₄H₆NiO₄), and the like, but is not limited thereto.

A chromate layer may be additionally formed on the anti-oxidation layer. The chromate layer may be formed by treatment in an aqueous solution having a chromic anhydride concentration of 3 to 7 g/L at room temperature, pH 5.0, and a current density of 0.5 A/dm² for 4 seconds.

A silane coupling agent layer may be formed on the copper foil with the anti-oxidation layer by immersion in an aqueous solution having a silane coupling agent concentration of 1 to 10 g/L at room temperature and pH 3-5 for 2 to 4 seconds.

The surface-treated copper foil of the present disclosure undergoing surface treatment by the above-described method includes nodule structures with a pillar shape extending in a direction perpendicular to a surface of the copper foil.

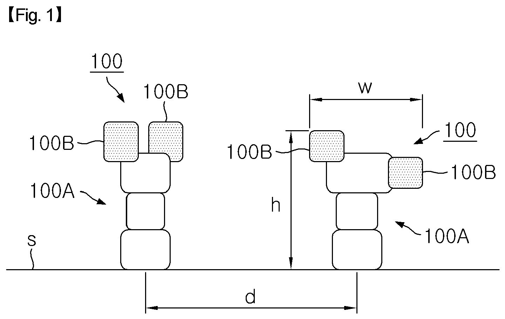

FIG. 1 is a schematic diagram of nodule structures on the surface of the copper foil according to an embodiment of the present disclosure.

The nodule structures of the present disclosure have a needle-like pillar-shape extending in a direction substantially perpendicular to the surface of the copper foil (forming an angle of 60 to 90 degrees relative to the copper foil surface). However, the nodule structures of the present disclosure are characterized by including a branch structure from a side surface or an end portion of the pillar structure.

Specifically, referring to FIG. 1, each nodule structure 100 of the present disclosure may include: a pillar part 100A extending in a direction substantially perpendicular to the copper foil surface S and forming a body; and branch parts 100B branching from a side surface or an upper surface of the pillar part. In the present disclosure, the pillar and branch parts constituting the nodule structure may be separate nodules or grains, or the pillar and branch parts each may be an assembly or aggregate of a plurality of nodules or grains, but are not limited thereto, and alternatively, the entire nodule structure may be composed of one nodule or grain.

In the present disclosure, the nodule structure has a needle-like or pillar-type structure, of which the aspect ratio representing the ratio of the height (h) to the width (w) of the structures exceeds 1. The aspect ratio (h/w) of the nodule structure may be preferably 1.2 or more, 1.4 or more, 1.5 or more, or 1.6 or more, and the aspect ratio is preferably 2.5 or less, 2.4 or less, 2.3 or less, 2.2 or less, 2.1 or less, or 2.0 or less.

In the present disclosure, the width (w) of the nodule structure may be 400 nm or less, preferably 130 to 350 nm. The height (h) of the nodule structure may be 600 nm or less, preferably 300 to 550 nm.

Particularly, the width (w) of the nodule structure is defined as the maximum value among width values measured on a cross section cut in a direction parallel to the copper foil surface at an arbitrary position of the nodule structure, and the height (h) of the nodule structure is defined as the maximum value among height values measured on a section cut in a direction perpendicular to the copper foil surface at an arbitrary position of the nodule structure. It will be understood that the sizes (width or height) of the pillar and branch parts constituting the nodule structure may be measured in the same manner as the width or height of the nodule structure described above.

In the present disclosure, the nodule structures are discretely distributed on the copper foil surface. The distribution mode of the nodule structures does not have a particular rule, but the distance d between the nodule structures may be 200 nm or more, preferably in the range of 250 to 600 nm.

The discrete degree in the surface-treated copper foil of the present disclosure may be expressed as the number of nodule structures per unit area. Illustratively, the density of the nodule structures may be 2 to 20/µm², 3 to 15/µm², 5 to 15/µm², or 5 to 10/µm². Unlike this, the discrete degree of the nodule structures in the present disclosure may be expressed as a ratio of the distance d and the width w of the nodule structures. For example, the distance d may preferably have a greater value than the width w in the nodule structures of the present disclosure. Illustratively, the ratio of the distance d to the width w of the nodule structure may be 1.5 or more, 1.6 or more, 1.7 or more, 1.8 or more, 4.0 or less, 3.5 or less, 3.0 or less, 2.5 or less, or 2.0 or less.

As shown, in the nodule structure in the present disclosure, the width and length of the branch parts are typically smaller than the width and height of the pillar parts. However, in the present disclosure, the branch parts are meant to a structure having a width or height of at least a predetermined value, for example, at least 50 nm, 60 nm, 70 nm, 80 nm, 90 nm, or 100 nm.

The surface-treated copper foil of the present disclosure exhibits high adhesive strength when attached to a resin substrate. This is presumed to be due to the anchoring effect by the nodule structures composed of pillar and branch parts.

In addition, the surface-treated copper foil of the present disclosure has a very low 10-point mean roughness (Rz) value while exhibiting high adhesive strength to a resin substrate. In spite of having nodule structures with a high aspect ratio, the surface-treated copper foil of the present disclosure may have a 10-point mean roughness value of 1.0 µm or less, 0.9 µm or less, 0.8 µm or less, 0.7 µm or less, or 0.6 µm or less, or 0.5 µm or less. The 10-point mean roughness Rz of the surface-treated copper foil of the present disclosure may be 0.2 µm or more or 0.3 µm or more. The wording "10-point mean roughness Rz" refers to the 10-point mean roughness Rz stipulated in the definition of 5.1 ten-point mean roughness of JIS B 0601-1994 "definition and indication of surface roughness".

Therefore, the surface-treated copper foil of the present disclosure can be applied to circuit boards considering high-frequency characteristics and can show high adhesion characteristics to even LCP polymers.

In the present disclosure, the surface-treated copper foil may be attached to a low-dielectric resin, a polyimide, a hydrocarbon, a polytetrafluoroethylene film, or an LCP resin to manufacture a copper clad laminate. The surface-treated copper foil of the present disclosure may have an adhesive strength of 0.7 kgf/cm or more with respect to a low dielectric resin, a polyimide, a hydrocarbon, a polytetrafluoroethylene film, or LCP. The adhesive strength may be an adhesive strength measured according to the JIS C6481 standard.

The above-described surface-treated copper foil, which is laminated on a resin substrate, may be used as a copper clad laminate, and this copper clad laminate may be used to manufacture a printed wiring board.

### [Mode for Invention]

Hereinafter, the present disclosure will be described in detail with reference to examples. However, these examples are shown by way of illustration and should not be construed as limiting the present disclosure in any way.

### <Example 1>

For the preparation of a copper foil by electroplating, a 2-L volume electrolyzer system enabling circulation at 20 L/min was prepared. Particularly, the temperature of a copper electrolyte was constantly maintained at 45°C. A dimensionally stable electrode (DSE) electrode plate with a thickness of 10 mm and a size of 10 cm x 10 cm was used as a cathode, and a titanium electrode plate having the same size and thickness as the cathode was used as an anode.

A fabric (product name: I2S, from ILJIN Materials) with a roughness (Rz) of 0.43 µm and a thickness of 12 µm was used as a raw foil.

A roughened layer was formed by electroplating at a solution temperature of 45°C and a current density of 16 to 20 A/dm² for 6 seconds while an aqueous solution of pH 6-7 containing 30 g/L of a copper salt (copper sulfate), 90 g/L of sulfuric acid, 0.3 g/L of cobalt, 0.8 g/L of tungsten, and 0.6 g/L of titanium was used as an electrolyte.

Then, an anti-oxidation layer was formed by plating at a solution temperature of 25°C, pH 2-4, and a current density of 1 A/dm² for 1 to 3 seconds in an aqueous solution containing 5 g/L of a nickel salt and 20 g/L of phosphoric acid (H₃PO₄) and plating at a current density of 1 A/dm² for 2 to 4 seconds in an aqueous solution containing 5 g/L of zinc and having pH 1-3.

Then, a chromate layer was formed in an aqueous solution having a chromic anhydride concentration of 5 g/L at room temperature under conditions of pH 5.0, and a current density of 0.5 A/dm² and a treatment time of 4 seconds.

The copper foil with the chromate layer was immersed in a solution of 1 to 10 g/L of a silane coupling agent for 3 seconds and then dried with hot air at a temperature of 100°C, thereby preparing a surface-treated copper foil.

### <Example 2>

A roughened layer, an anti-oxidation layer, a chromate layer, and a silane coupling agent layer were formed by the same method as in Example 1 except that a fabric (product name: I2S, from ILJIN Materials) with a roughness (Rz) of 0.61 µm was used as a raw foil.

### <Comparative Example 1>

Similar to Example 1, a fabric (product name: I2S) with a roughness (Rz) of 0.43 µm and a thickness of 12 µm was used as a raw foil. A roughened layer was formed by electroplating at a solution temperature of 45°C and a current density of 7 to 12 A/dm² for 8 seconds while an aqueous solution of pH 3.5-5.5 containing 50 g/L of copper sulfate and 100 g/L of sulfuric acid was used.

Then, an anti-oxidation layer, a chromate layer, and a silane coupling agent layer were formed under the same conditions as in Example 1.

### <Comparative Example 2>

Similar to Example 1, a fabric (product name: I2S) with a roughness (Rz) of 0.43 µm and a thickness of 12 µm was used as a raw foil. A primary roughened layer was formed by electroplating at a solution temperature of 45°C and a current density of 6 to 11 A/dm² for 4 seconds while an aqueous solution of pH 6-7 containing 50 g/L of copper sulfate and 100 g/L of sulfuric acid was used. Then, a secondary roughened layer was formed by two times of electroplating at a solution temperature of 45°C and a current density of 10 to 14 A/dm² for 4 seconds while an aqueous solution of pH 1-3 containing 250 g/L of copper sulfate and 100 g/L of sulfuric acid was used.

Then, an anti-oxidation layer, a chromate layer, and a silane coupling agent layer were formed under the same conditions as in Example 1.

### <Evaluation of properties>

Each of the surface-treated copper foil samples prepared in the examples and comparative examples were measured for properties. Property evaluation items and measurement methods were as follows.

### a. 10-Point mean roughness R_{z} (unit: µm)

The 10-point mean roughness R_{z} of a copper foil after surface treatment was measured by using a surface roughness meter according to the JIS B0601 standard.

### b. Nodule grain size, nodule distance, and nodule density

A SEM image of the surface of a copper foil after surface treatment was taken using a scanning electron microscope, and the grain diameters of 100 nodule structures in an area of 100 µm x 100 µm were measured and the mean value thereof was obtained. Similarly, the distances between any nodules in an area of 100 µm x 100 µm on the SEM image were measured at 100 points.

The density of nodules (#/µm²) was obtained by counting the number of nodule structures in an area of 1 µm X 1 µm on the SEM image of a surface of a copper foil.

### c. Adhesive strength (unit: kgf/cm)

Samples were prepared by preparing an LCP resin (manufacturer: COPOLYMEN^{®}) with a thickness of 50 µm and pressing the surface-treated copper foil samples of Examples 1 and 2 and Comparative Examples 1 and 2 with a width of 10 mm on the LCP resin, respectively. The conditions for pressing were a temperature of 350°C, a pressure of -1.8 Mpa, and 5 minutes. The prepared test samples were measured for adhesive strength by the 90° peeling method according to JIS C 6471 8.1.

### d. Glossiness (Gs 60°)

A surface of a copper foil after surface treatment was measured for glossiness according to the JIS Z 8741 standard.

### e. Color difference measurement

A colorimeter (manufacturer: KONICA MINOLTA) was prepared, and L*, a*, and b* values of a surface of a copper foil were measured by a specular component excluded (SCE) method after surface treatment of the copper foil.

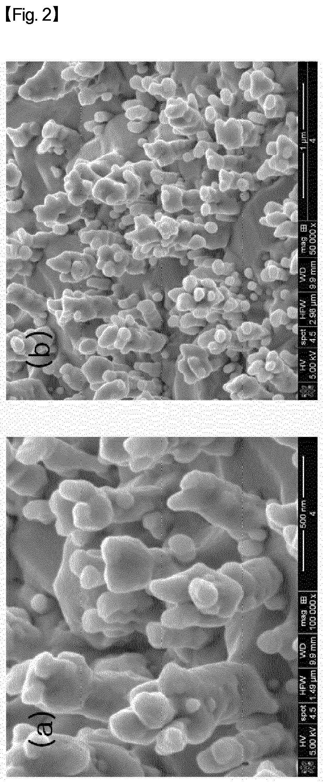

FIGS. 2 to 4 are electron microscopic images of the surfaces of the surface-treated copper foils prepared in Example 1, Comparative Example 1, and Comparative Example 2, respectively. Panels (a) and (b) in each figure show images with different magnifications.

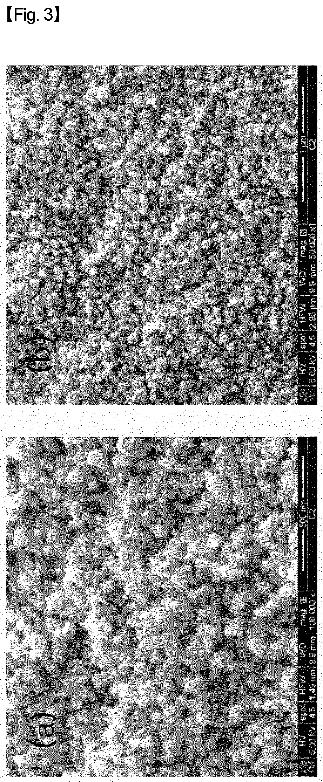

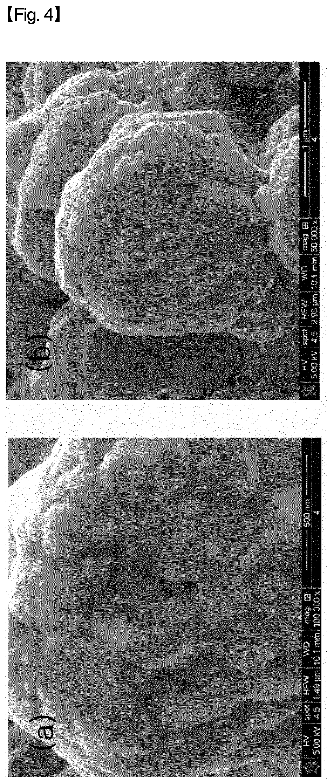

As shown in FIG. 2, the surface-treated copper foil prepared in Example 1 included needle-like pillar-shaped nodule structures extending at an angle of 60 to 90 degrees relative to the surface of the copper foil as described with respect to FIG. 1. Most of the nodule structures included a plurality of branch parts branching from a side surface or an end portion of the pillar shape. These structures were significantly different from the nodule structures shown in FIGS. 3 and 4.

The width and height of the nodule structures and the distance between the nodule structures on the electron microscopic image were measured at different positions of the sample of Example 1, and the mean values at each measurement round are shown in Table 1 below.

**TABLE 1**

| Division | Width (w) | Length (h) | Distance (d) |
|---|---|---|---|
| 1 | 293 | 492 | 260 |
| 2 | 250 | 383 | 498 |
| 3 | 254 | 332 | 478 |
| 4 | 250 | 410 | 411 |
| 5 | 285 | 529 | 372 |
| 6 | 313 | 377 | 311 |
| 7 | 282 | 381 | 283 |
| 8 | 196 | 465 | 519 |
| 9 | 305 | 503 | 328 |
| 10 | 199 | 392 | 452 |
| 11 | 211 | 344 | 350 |
| 12 | 138 | 317 | 484 |
| 13 | 238 | 282 | 325 |
| 14 | 184 | 390 | 502 |
| 15 | 278 | 410 | 567 |

The measured nodule widths had a minimum value of 138 nm and a maximum value of 313 nm; the measured nodule heights had a minimum value of 282 nm and a maximum value of 529 nm; and the measured nodule distances had a minimum value of 260 nm and a maximum value of 567 nm. The nodule density at each measurement position was 3 to 12/µm². Table 2 below shows the summary of property evaluation results.

**TABLE 2**

| Division | Roughness (Rz) | Glossiness (GS60) | Nodule grain size (nm) | Adhesive strength (kgf/cm) | L* | a* | b* |
|---|---|---|---|---|---|---|---|
| Example 1 | 0.49 | 7.6 | <300 | 1.1 | 60.48 | 27.33 | 18.64 |
| Example 2 | 0.7 | 7.2 | <300 | 1.2 | 64.14 | 26.72 | 16.47 |
| Comparative Example 1 | 0.61 | 3.0 | <100 | 0.6 | 27.80 | 5.39 | 7.99 |
| Comparative Example 2 | 1.4 | 1.2 | >2500 | 0.5 | 65.14 | 20.86 | 15.64 |

Referring to Table 2, the samples of Examples 1 and 2 showed high adhesive strength despite low surface roughness.

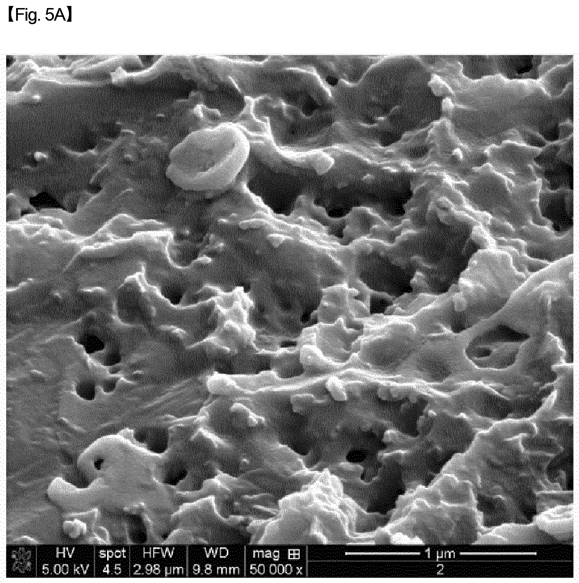

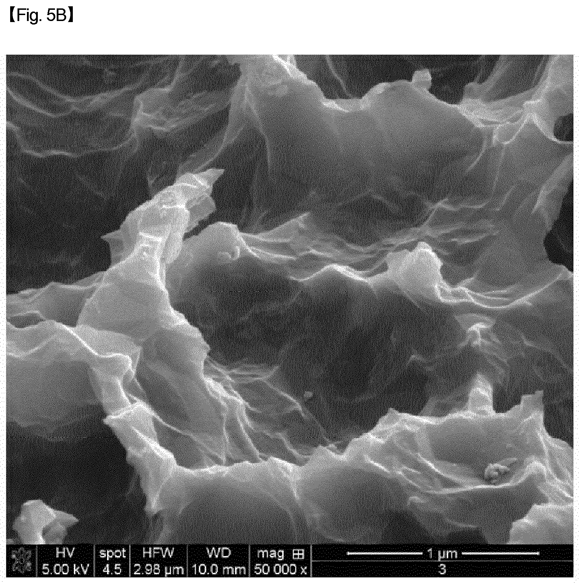

FIGS. 5A and 5B are images of surfaces of LCP resins after the surface-treated copper foils prepared in Example 1 and Comparative Example 2 were attached to the LCP resins and then the copper foils were removed by complete etching.

Referring to FIG. 5A, the nodule structures according to the example of the present disclosure had a high aspect ratio and a branch structure, and thus, an adhesive surface with a complicated shape was formed between the copper foil and the LCP resin, leading to strong binding therebetween.

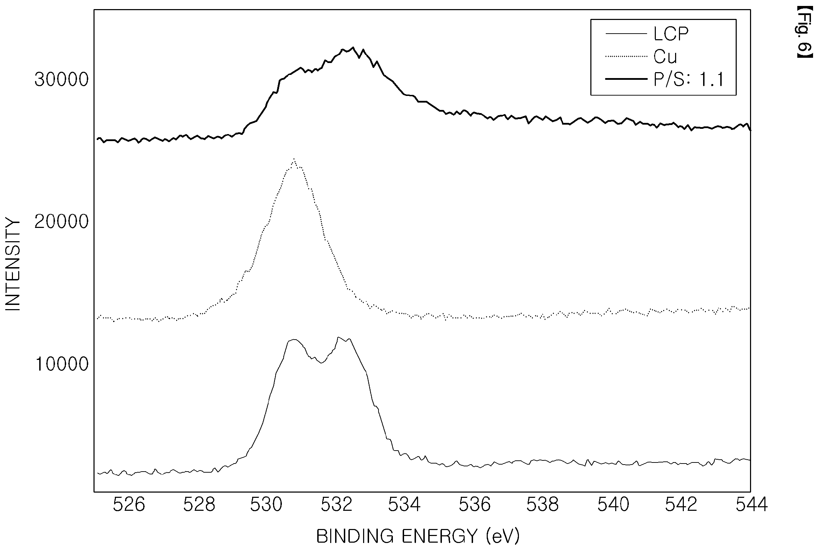

FIG. 6 is a graph showing XPS analysis results of the sample before and after adhesive strength measurement of the surface-treated copper foil prepared in Example 1. In the graph, "LCP" and "Cu" indicate the XPS analysis data of the LCP resin and the surface-treated copper foil before attachment, and "P/S: 1.1" represents the XPS analysis data of the surface of the copper foil after adhesive strength measurement of the surface-treated copper foil sample prepared in Example 1.

Referring to FIG. 6, the O₁ₛ peak of the surface of the copper foil (P/S: 1.1) after adhesive strength measurement was similar to the O₁ₛ peak of LPS. These results confirmed that the transgranular fracture was accompanied in the LCP at the time of adhesive strength measurement, and the resin transgranular fracture mechanism indicates that high adhesive strength was formed at the interface between the surface-treated copper foil of the copper clad laminate and the resin.

Although preferable embodiments of the present disclosure have been described in detail, it would be understood that various modifications of the described embodiment are possible by those skilled in the art to which the present disclosure pertains without departing from the scope of the present disclosure. Therefore, the scope of right of the present disclosure shall not be defined by the described embodiment, but shall be defined by the claims to be described later and their equivalents.

### [Industrial Applicability]

The present invention is applicable to a copper foil, a copper clad laminate, and a printed wiring board.

## Claims

1. A surface-treated copper foil comprising a surface-treated surface formed by surface treatment of a raw foil,
wherein the surface-treated copper foil comprises a plurality of nodule structures formed on the surface-treated surface, the nodule structures each comprising: a pillar part extending from the surface of the surface-treated copper foil; and a branch part extending from a side surface or an end portion of the pillar part, and
wherein the surface-treated surface has a surface roughness (Rz) of 1.0 um or less.

2. The surface-treated copper foil of claim 1, wherein the surface roughness (Rz) of the surface-treated surface is 0.7 um or less.

3. The surface-treated copper foil of claim 1, wherein the width (w) of the nodule structures is 400 nm or less and the ratio (h/w) of the height (h) to the width (w) of the nodule structures exceeds 1.

4. The surface-treated copper foil of claim 3, wherein the ratio (h/w) of the height (h) to the width (w) of the nodule structures is 1.2 or more.

5. The surface-treated copper foil of claim 3, wherein the width (w) of the nodule structures is 130 to 350 nm.

6. The surface-treated copper foil of claim 3, wherein the height (h) of the nodule structures is 300 to 550 nm.

7. The surface-treated copper foil of claim 3, wherein the distance (d) between the nodule structures is 200 nm or more.

8. The surface-treated copper foil of claim 7, wherein the distance (d) between the nodule structures is 250 to 600 nm.

9. The surface-treated copper foil of claim 1, wherein the density of the nodule structures is 2 to 20/µm².

10. The surface-treated copper foil of claim 1, wherein the glossiness of the surface-treated surface of the surface-treated copper foil is less than 10.

11. A copper clad laminate comprising the surface-treated copper foil of any one of claims 1 to 10 laminated on a resin substrate.

12. The copper clad laminate of claim 11, wherein the resin substrate includes an LCP resin.
